# EUROPEAN PATENT APPLICATION

(11) **EP 3 751 386 A1**
(43) Date of publication of application: **16.12.2020**
(21) Application number: 20178236.4
(22) Date of filing: 04.06.2020
(51) Int. Cl.: G06F 1/16, G02F 1/1333, G09G 3/32, H01L 27/32

(54) **ELECTRONIC DEVICE AND TILED ELECTRONIC DEVICE**

(30) Priority: 10.06.2019 US 201962859208 P; 02.03.2020 CN 202010137076
(71) Applicant: InnoLux Corporation, Chu-Nan, Miao-Li County 35053 (TW)
(72) Inventor: YUEH, Jui-Jen, Miao-Li County 35053 (TW); LEE, Kuan-Feng, Miao-Li County 35053 (TW)
(74) Representative: Becker, Eberhard

(57) **Abstract**

The disclosure provides an electronic device (100a) and a tiled electronic device. The electronic device (100a) includes a substrate (110a), a plurality of signal lines (120), and a plurality of conductive patterns (130a). The substrate has a first surface (112), a second surface (114) opposite to the first surface (112), and a third surface (116a) therebetween. The plurality of signal lines (120) are disposed on the first surface (112). The plurality of conductive patterns (130a) are directly formed on the third surface (116a). M of the plurality of signal lines (120) and N of the plurality of conductive patterns (130a) are electrically connected. M and N are natural numbers, and M is greater than N.

## Description

### BACKGROUND

### Technical Field

The disclosure relates to an electronic device, and in particular, to an electronic device with a narrow bezel and a tiled electronic device formed by tiling the above electronic device.

### Description of Related Art

Today, many large-size electronic devices may be formed through tiling. However, a high-resolution electronic device has a large quantity of signal lines, and such tiled electronic devices have a seamless requirement, which significantly increases the process difficulty or affects the process yield.

### SUMMARY

According to an embodiment of the disclosure, an electronic device includes a substrate, a plurality of signal lines, and a plurality of conductive patterns. The substrate has a first surface, a second surface opposite to the first surface, and a third surface therebetween. The plurality of signal lines are disposed on the first surface. The plurality of conductive patterns are directly formed on the third surface. M of the plurality of signal lines and N of the plurality of conductive patterns are electrically connected. M and N are natural numbers, and M is greater than N.

According to another embodiment of the disclosure, a tiled electronic device includes a first electronic device and a second electronic device disposed side by side. Each of the first electronic device and the second electronic device includes a substrate, a plurality of signal lines, and a plurality of conductive patterns. The substrate has a first surface, a second surface opposite to the first surface, and a third surface therebetween. The plurality of signal lines are disposed on the first surface. The plurality of conductive patterns are directly formed on the third surface. M of the plurality of signal lines and N of the plurality of conductive patterns are electrically connected. M and N are natural numbers, and M is greater than N.

To make the features and advantages of the disclosure more comprehensible, a detailed description is made below with reference to the accompanying drawings by using embodiments.

### BRIEF DESCRIPTION OF THE DRAWINGS

The accompanying drawings are included to provide a further understanding of the disclosure, and are incorporated in and constitute a part of the specification. The drawings illustrate embodiments of the disclosure and, together with the description, serve to explain the principles of the disclosure.
FIG. 1A is a schematic cross-sectional view of an electronic device according to an embodiment of the disclosure.
FIG. 1B is a schematic top view of the electronic device in FIG. 1A.
FIG. 1C is a schematic diagram of an enlarged part, such as a region B, of the electronic device in FIG. 1B.
FIG. 2A to FIG. 2D are schematic cross-sectional views of a substrate of an electronic device according to a plurality of embodiments of the disclosure.
FIG. 3A to FIG. 3C are schematic cross-sectional views of a manufacturing method of an electronic device according to an embodiment of the disclosure.
FIG. 4 is a schematic cross-sectional view of a tiled electronic device according to an embodiment of the disclosure.
FIG. 5 is a schematic cross-sectional view of a tiled electronic device according to another embodiment of the disclosure.
FIG. 6 is a schematic cross-sectional view of a tiled electronic device according to another embodiment of the disclosure.

### DESCRIPTION OF THE EMBODIMENTS

The disclosure may be understood with reference to the following detailed description and the accompanying drawings. It should be noted that, for ease of understanding by readers and concise drawings, a plurality of drawings in the disclosure merely show a part of an electronic device, and specific elements in the drawings are not drawn to scale. In addition, the quantity and size of the elements in the drawings are merely exemplary, and are not intended to limit the scope of the disclosure.

Some words are used to refer to specific elements in the whole specification and the appended claims in the disclosure. A person skilled in the art should understand that an electronic device manufacturer may use different names to refer to the same elements. The specification is not intended to distinguish elements that have the same functions but different names. In the specification and the claims, words such as "include", "comprise", and "have" are open words, and should be interpreted as "including, but not limited to". Therefore, when terms "include", "comprise", and/or "have" are used in the description of the disclosure, the presence of corresponding features, regions, steps, operations and/or components is specified without excluding the presence of one or more other features, regions, steps, operations and/or components.

The directional terms mentioned herein, like "above", "below", "front", "back", "left", and "right", refer to the directions in the accompanying drawings. Therefore, the directional terms are only used for illustration instead of limiting the disclosure. In the accompanying drawings, common features of a method, a structure and/or a material used in a specific embodiment are shown in the drawings. However, these drawings should not be construed as defining or limiting the scope or nature of these embodiments. For example, the relative sizes, thicknesses and positions of films, regions and/or structures may be reduced or enlarged for clarity.

When a corresponding component such as a film or a region is referred to as being "on another component", it may be directly on the another component, or there may be other components between the two components. In another aspect, when a component is referred to as being "directly on another component", there is no component between the two components. In addition, when a component is referred to as being "on another component", the two components have an up and down relationship in a top view. The component may be located above or below the another component, and the up and down relationship depends on the orientation of the device.

It should be understood that, when a component or a film is referred to as being "connected to" another component or film, it may be directly connected to the another component or film, or there are components or films inserted between the two components or films. When a component or a film is referred to as being "directly connected to" another component or film, there is no component or film inserted between the two components or films. In addition, when a component is referred to as being "coupled to another component (or a variant thereof)", it may be directly connected to the another component, or may be indirectly connected to (for example, electrically connected to) the another component through one or more components.

The terms "approximate", "identical with" or "the same as", or "substantially" or "generally" are generally interpreted as within 20% of the given value or range, or interpreted as within 10%, 5%, 3%, 2%, 1%, or 0.5% of the given value or range.

Ordinal numbers used in the specification and the claims, like "first" and "second", are used to modify the elements, and do not imply or represent that the (or these) element (or elements) has (or have) any ordinal number, and do not indicate any order between an element and another element, or an order in a manufacturing method. These ordinal numbers are merely used to clearly distinguish an element having a name with another element having the same name. Different terms may be used in the claims and the specification, so that a first component in the specification may be a second component in the claims.

It should be noted that in the following embodiments, features in a plurality of embodiments may be replaced, recombined, or mixed to complete other embodiments without departing from the spirit of the disclosure. The features of the embodiments may be used in any combination without departing from the spirit of the disclosure or conflicting with each other.

The electrical connection or coupling described in the disclosure may refer to a direct connection or an indirect connection. In the case of a direct connection, terminals of two elements on a circuit are directly connected or interconnected by a conductor segment. In the case of an indirect connection, there is a combination of one of elements of non-conductor segments such as switches, diodes, capacitors, and inductors and at least one conductive segment or resistor, or a combination of at least two of the elements of non-conductor segments above and at least one conductive segment or resistor between terminals of two elements on a circuit.

In the disclosure, the electronic device may be, but not limited to, a display device including a light-emitting element, a light source device, a backlight device, a sensing device, an antenna device, a tiled device, or a combination of the foregoing functions. The electronic device may be a bendable or flexible electronic device. The electronic device may include, for example, liquid crystals and light-emitting diodes (LEDs). The light-emitting diode may include, for example but not limited to, an organic light-emitting diode (OLED), a sub-millimeter light-emitting diode (mini LED), a micro light-emitting diode (micro LED), a quantum dot (QD) light-emitting diode (QLED or QDLED), fluorescence, phosphor, other suitable materials, or a combination of the foregoing materials. The antenna device may include, for example but not limited to, a liquid crystal antenna. The following illustrates the disclosure by using but not limited to an example that the display device is used as an electronic device or a tiled device. Furthermore, the electronic device may be applied to any electronic product or electronic equipment, for example but not limited to, a television, a tablet computer, a notebook computer, a mobile phone, a camera, a wearable device, an electronic entertainment device, a communication antenna.

In the following embodiments, same or similar reference numerals are used to indicate same or similar elements, and details may be omitted in the description. In addition, the features in the embodiments may be used in any combination without departing from the spirit of the disclosure or conflicting with each other, and simple equivalent changes and modifications made to the specification or the claims shall still fall within the scope of the disclosure. In addition, the terms "first", "second", and the like mentioned in the specification or the claims are used only to name discrete elements or to distinguish between different embodiments or ranges, but are not intended to define the upper or lower limit of the number of elements or the manufacturing or arrangement order of the elements.

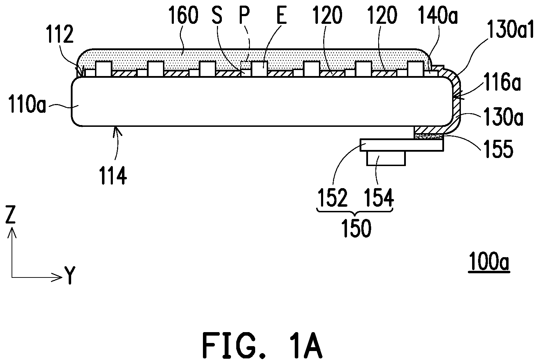

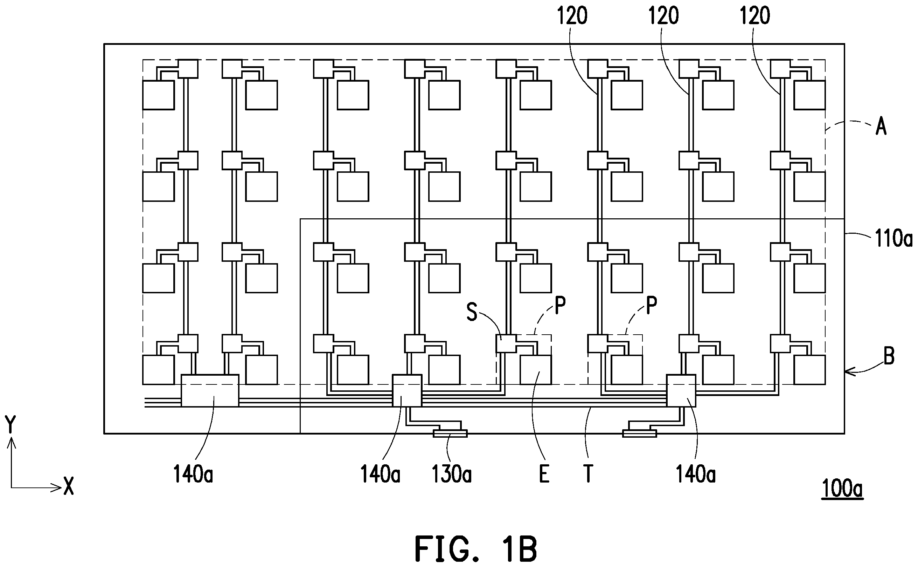

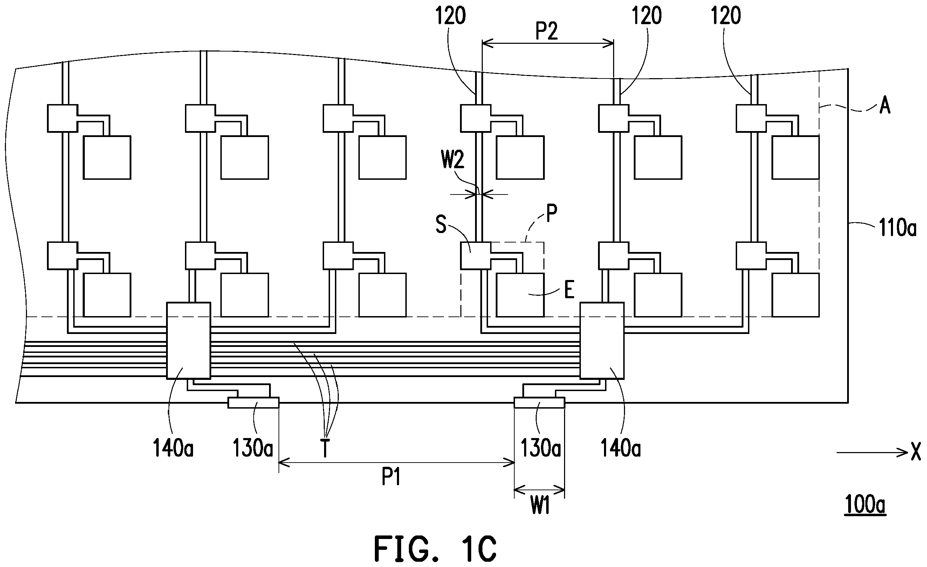

FIG. 1A is a schematic cross-sectional view of an electronic device according to an embodiment of the disclosure. FIG. 1B is a schematic top view of the electronic device in FIG. 1A. FIG. 1C is a schematic diagram of an enlarged part, such as a region B, of the electronic device in FIG. 1B. First, referring to FIG. 1A and FIG. 1B, in the present embodiment, an electronic device 100a includes a substrate 110a, a plurality of signal lines 120, and a plurality of conductive patterns 130a. The substrate 110a has a first surface 112, a second surface 114 opposite to the first surface 112, and a third surface 116a therebetween. In other words, the third surface 116a is located between the first surface 112 and the second surface 114. The plurality of signal lines 120 are disposed on the first surface 112. The plurality of conductive patterns 130a are directly formed on the third surface 116a. That is, the plurality of conductive patterns 130a are disposed directly on the third surface 116a. M of the plurality of signal lines 120 and N of the plurality of conductive patterns 130a are electrically connected. M and N are natural numbers, and M is greater than N.

Referring to FIG. 1A and FIG. 1B, the electronic device 100a further includes a plurality of pixels P, disposed on the substrate 110a. The plurality of pixels P define an active region A. It should be noted that, to enable FIG. 1B to present a relationship between related elements, a quantity of pixels P in FIG. 1B is not exactly corresponding to a quantity of pixels P in FIG. 1A, and is only an example.

The active region A may be defined, for example, as a region including all light-emitting regions E. In an embodiment, if the electronic device 100a includes a liquid crystal device (LCD) or an OLED device, the light-emitting region E may be defined, for example, by using a boundary of an opening region of a black matrix (not shown). The black matrix may include, for example, a light blocking material (for example but not limited to, a black resistor, or an insulating material with a function of blocking the light, or a metal). In other embodiments, if the electronic device 100a includes an LED (light emitting diode) device, the light-emitting region E may be defined, for example, by an upper surface of an LED. In an embodiment, if the electronic device 100a is a sensing device or an antenna device, the active region A may be defined, for example, by a sensing region (not shown). The following first uses an example that the electronic device 100a is an LED device, but the disclosure is not limited thereto. In some embodiments, a material of the substrate 110a may include, for example but not limited to, glass, quartz, ceramics, sapphire, polyimide (PI), polyethylene terephthalate (PET), other suitable materials, or a combination of the foregoing materials. In some embodiments, the substrate 110a may include a rigid substrate, a soft substrate, or a flexible substrate. In some embodiments, a region of the pixel P includes, but not limited to, a switch unit S (for example but not limited to, a thin-film transistor (TFT)) and a drive circuit. In some embodiments, the third surface 116a of the substrate 110a is, for example, a side surface of the substrate 110a, and the plurality of conductive patterns 130a are formed (or disposed), for example, on the side surface of the substrate 110a. In some embodiments, the plurality of conductive patterns 130a may extend from the third surface 116a to a part of the first surface 112 and/or a part of the second surface 114. In some embodiments (as shown in FIG. 1B), M (for example, 3) of the plurality of signal lines 120 and N (for example, 1) of the plurality of conductive patterns 130a are electrically connected. M and N are natural numbers, and M is greater than N. However, the disclosure is not limited thereto. In an embodiment (not shown), M may be 2, and N is 1. Alternatively, M may be less than equal to 16. However, the disclosure is not limited thereto. In other embodiments, a quantity of signal lines 120 electrically connected to one conductive pattern 130a may be adjusted according to a requirement. In some embodiments, the plurality of signal lines 120 may be, for example, a plurality of scan lines or a plurality of data lines. Through the foregoing design, a quantity of the conductive patterns 130a formed or disposed on the third surface 116 (that is, the side surface of the substrate 110a) may be, for example, less than a quantity of the signal lines 120, which can increase the process yield or achieve a slim border effect, so that the electronic device 100a is suitable for a tiled electronic device.

In some embodiments, a material of the signal lines 120 includes, for example, tantalum, titanium, aluminum, copper, tungsten, other suitable materials, or a combination of the foregoing materials. In some embodiments, a material of the conductive patterns 130a includes, for example, silver, tantalum, titanium, aluminum, copper, tungsten, other suitable materials, or a combination of the foregoing materials. In an embodiment, the conductive pattern 130a may include a single-layer structure or a multi-layer structure. In some embodiments, an insulation layer (not shown) may be, for example, disposed on an outer surface of the conductive pattern 130a, to protect the conductive pattern 130a or reduce oxidation of the conductive pattern 130a. In an embodiment, a thickness of the conductive pattern 130a is defined as a minimum distance between a surface 130a1 of the conductive pattern 130a and the third surface 116a in a Y direction and may range from, for example but not limited to, 3 micrometers (um) to 10 um (that is, 3 um ≤ the thickness ≤ 10 um). In an embodiment, a thickness of the conductive pattern 130a is, for example, 5 um to 10 um (that is, 5 um ≤ the thickness ≤ 10 um).

Referring to FIG. 1C, the M (for example, 3) of the plurality of signal lines 120 and the N (for example, 1) of the plurality of conductive patterns 130a may be, for example, selectively and electrically connected in an one-to-one fashion. Specifically, the electronic device 100a further includes a demultiplexer (demux) 140a. The demux 140a is disposed on the substrate 110a, and at least a portion of the demux 140a is located in the active region A. However, the disclosure is not limited thereto. In other embodiments, the demux 140a may be, for example, located outside the active region A. In some embodiments, the M (for example, 3) of the plurality of signal lines 120 and the N (for example, 1) of the plurality of conductive patterns 130a may be, for example, selectively and electrically connected via the demux 140a. It should be noted that, the phrase "selectively and electrically connected" means that in different operation sequences, one of the M signal lines 120 may turn on one of the N conductive pattern 130a via the demux 140a. In an embodiment, the demux 140a includes, for example, three switch elements (not shown). The switch element includes, for example, a TFT. The three switch element may be, for example, configured to control switches of the 3 signal lines 120 respectively. In an embodiment, for example, three control lines T may be connected between two demuxes 140a, to transmit electrical signals via the three control lines T to selectively turn on or off the 3 signal lines 120. However, the disclosure is not limited thereto. A quantity of control lines T connected between two demuxes 140a may be adjusted according to a requirement. In an embodiment (not shown), a quantity of signal lines 120 connected to one demux 140a may be, for example but not limited to, the same as the quantity of control lines T connected between two demuxes 140a. In some embodiments, a material of the control line 120 includes, for example but not limited to, tantalum, titanium, aluminum, copper, tungsten, other suitable materials, or a combination of the foregoing materials. In some embodiments, the conductive patterns 130a may be directly electrically connected to the demux 140a. In other embodiments (not shown), an insulation layer (not shown) may be disposed between the demux 140a and the conductive patterns 130a, and the conductive patterns 130a and the demux 140a may be electrically connected by a conductive hole (not shown) penetrating the insulation layer. In some embodiments, the signal lines 120 and/or the conductive patterns 130a may be formed by screen printing or other appropriate means.

For a high-resolution product, a short circuit may occur due to a high density of lines during line arrangement, which increases the process difficulty. Therefore, in the above design of the disclosure, the demux 140a is disposed to reduce pin quantities of peripheral terminals, which can resolve the above-mentioned problem. Referring to FIG. 1C, in some embodiments, a pitch PI between adjacent conductive patterns 130a may be, for example but not limited to, greater than a pitch P2 between adjacent signal lines 120. In some embodiments, a width W1 of the conductive pattern 130a may be, for example, greater than a width W2 of the signal line 120. The width W1 and the width W2 are, for example, a maximum width measured in an X direction. The X direction may be approximately a direction in which the plurality of conductive patterns 130a are arranged.

Referring to FIG. 1A again, the electronic device 100a further includes a circuit 150, disposed on the second surface 114 of the substrate 110a. The circuit 150 is electrically connected to the plurality of signal lines 120 via the plurality of conductive patterns 130a. Herein, the circuit 150 includes, for example, a flexible circuit board 152 and/or an integrated circuit 154. The integrated circuit 154 is, for example, electrically connected to the flexible circuit board 152. In some embodiments, the circuit 150 may be, but not limited to, electrically connected to the conductive patterns 130a by using an anisotropic conductive adhesive 155. In some embodiments, the electronic device 100a further includes an encapsulation colloid 160, to encapsulate or protect elements, for example, the signal lines 120, the switch unit S, the drive circuit, and/or the demux 140a, under the encapsulation colloid 160.

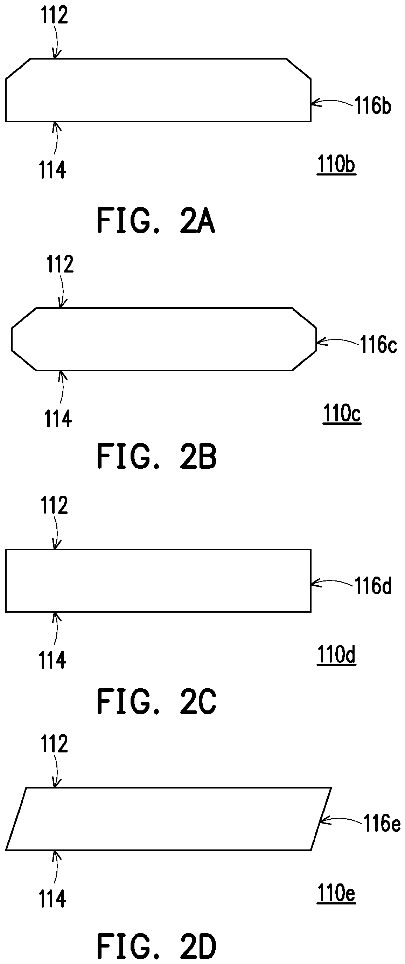

It should be noted that a structure form of the third surface 116a of the substrate 110a is not limited in the present embodiment. In the foregoing embodiment, the third surface 116a of the substrate 110a may be, for example, designed in other forms at a joint between the first surface 112 and the second surface 114. FIG. 2A to FIG. 2D are schematic cross-sectional views of a substrate of an electronic device according to a plurality of embodiments of the disclosure. In an embodiment of FIG. 2A, a joint between a third surface 116b and a first surface 112 may be designed, but not limited to, in a shape of a bevel, an arc, or a plurality of stairs. In an embodiment of FIG. 2B, each of a joint between a third surface 116c and a first surface 112 and a joint between the third surface 116c and a second surface 114 may be designed, but not limited to, in a shape of a bevel (or an arc). In an embodiment of FIG. 2C, an angle between a third surface 116d of a substrate 110d and a first surface 112 (or a second surface 114) is approximately, but not limited to, a right angle. In an embodiment of FIG. 2D, a shape of a substrate 110e presents, for example, a parallelogram, and an angle between a third surface 116e of the substrate 110e and a first surface 112 (or a second surface 114) is not a right angle.

It should be noted herein that the following embodiments follow the reference numerals of elements and a part of content of the foregoing embodiment, a same reference numeral is used to represent same or similar elements, and descriptions of same technical content are omitted. For the description of the omitted part, refer to the foregoing embodiment. Details are not repeated in the following embodiments.

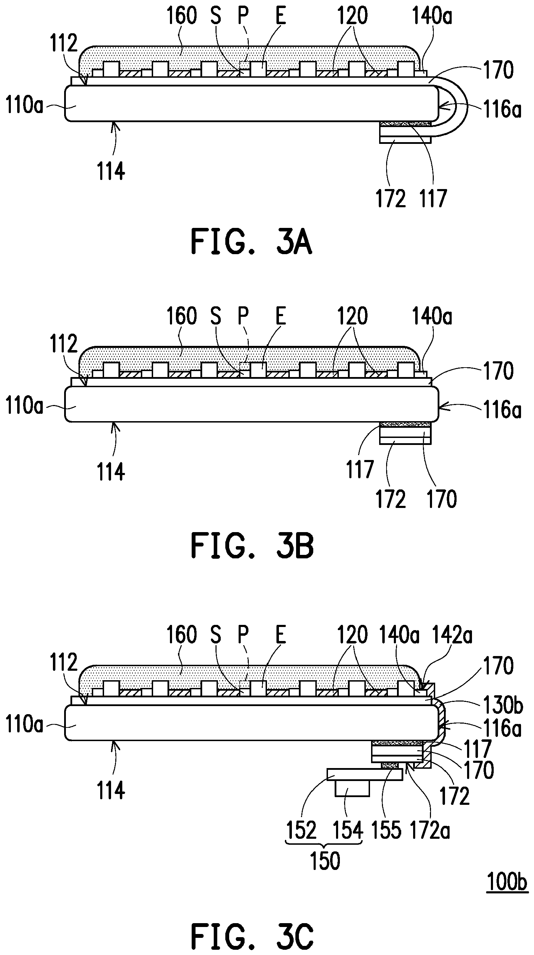

FIG. 3A to FIG. 3C are schematic cross-sectional views of a manufacturing method of an electronic device according to an embodiment of the disclosure. A manufacturing method of an electronic device 100b in the present embodiment includes the following steps: First, a substrate 110a is provided. Then, a flexible thin film 170 is disposed on the substrate 110a. For example, a circuit 172 has been disposed on the flexible thin film 170. In some embodiments, the flexible thin film 170 may be, for example but not limited to, directly disposed on a first surface 112 covering the substrate 110a. In some embodiments, the flexible thin film 170 is, for example, partially correspondingly bent to a third surface 116a of the substrate 110a but not in contact with the third surface 116a. In some embodiments, the flexible thin film 170 is, for example, partially bent to a second surface 114 of the substrate 110a via the third surface 116a of the substrate 110a, and partially fastened to the second surface 114 by using an adhesive layer 117. Then, signal lines 120, a demux 140a, a switch unit S, and/or a drive circuit are, for example but not limited to, disposed on the flexible thin film 170 located on the first surface 112, and the circuit 172 is, for example but not limited to, disposed on the flexible thin film 170 located on the second surface 114. In some embodiments, the circuit 172 includes, for example but not limited to, a gate drive circuit (GOP), an electrostatic discharge (ESD) protective circuit, and/or a metal wire. Then, an encapsulation colloid 160 is formed or disposed on the flexible thin film 170. The encapsulation colloid 160 may cover at least the plurality of signal lines 120, the switch unit S, the drive circuit, and/or the demux 140a. In other embodiments (not shown), the circuit 172 may partially, for example, disposed on the flexible thin film 170 located on the first surface 112.

Next, referring to FIG. 3A and FIG. 3B, the flexible thin film 170 is partially removed. Specifically, for example, the flexible thin film 170 located on the third surface 116a is removed to expose the third surface 116a of the substrate 110a. In some embodiments, for example, the flexible thin film 170 adjacent to the third surface 116a and located on the first surface 112 is partially removed to expose a part of the first surface 112. In some embodiments, for example, the flexible thin film 170 adjacent to the third surface 116a and located on the second surface 114 is partially removed to expose a part of the second surface 114. In some embodiments, the flexible thin film 170 may be removed, for example, by laser cutting, mechanical cutting, or other appropriate means.

Then, referring to FIG. 3C, in some embodiments, conductive patterns 130b are directly formed or disposed on the third surface 116a of the substrate 110a. In some embodiments, the conductive patterns 130b are formed or disposed, for example, on a part of the first surface 112 and/or the second surface 114. In some embodiments, the conductive patterns 130b are disposed, for example, on a part (for example, an upper surface 142a) of the demux 140a. In some embodiments, the conductive patterns 130b are, for example but not limited to, formed or disposed on a side surface of the adhesive layer 117 and/or a side surface of the flexible thin film 170, and extend to a lower surface 172a of the circuit 172. In some embodiments, the circuit 172 and the demux 140a are electrically connected via, but not limited to, the conductive patterns 130b. Through the foregoing design, a contact area between the substrate 110a and the conductive patterns 130b is increased, and structure reliability of the conductive patterns 130b is improved. In other embodiments (not shown), the conductive patterns 130b may be optionally not disposed on the upper surface 142a and the lower surface 172a. Finally, in some embodiments, a circuit 150 is electrically connected to the circuit 172 via an anisotropic conductive adhesive 155. So far, the electronic device 100b is completely manufactured. The foregoing steps are only an example, and the process may be properly adjusted according to a requirement. Through the foregoing process, the circuit 172 is first formed or disposed on the flexible thin film 170, and the flexible thin film 170 is partially bent to the second surface 114, which can simplify process steps. For example, layers located on the first surface 112 and the second surface 114 may be unnecessarily formed separately. For example, the circuit 172 may be manufactured together with some of the signal lines 120, the demux 140a, the switch unit S, and/or the drive circuit. In addition, the flexible thin film 170 is partially removed to expose the third surface 116a of the substrate 110a, so that the substrate 110a has a narrower bezel, and a bezel narrowing effect is improved.

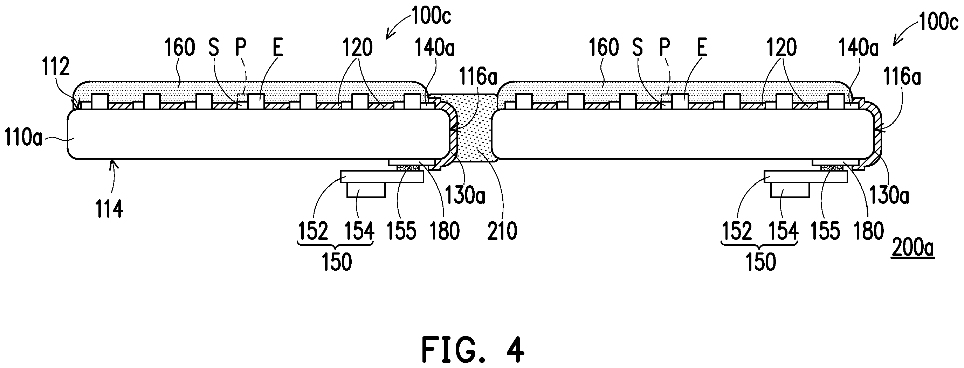

FIG. 4 is a schematic cross-sectional view of a tiled electronic device according to an embodiment of the disclosure. Referring to FIG. 4, in some embodiments, the tiled electronic device 200a includes, but not limited to, two electronic devices 100c (which may be referred to as a first electronic device and a second electronic device) tiled with each other. Referring to FIG. 1A and FIG. 4, the electronic device 100c is similar to the electronic device 100a in FIG. 1A, which differ as follows: The flexible thin film 170 may be optionally not disposed on the electronic device 100c, a circuit 180 is, for example, disposed on the second surface 114, and the circuit 180 may be electrically connected between the conductive pattern 130a and the anisotropic conductive adhesive 155. In some embodiments, the circuit 180 includes, for example but not limited to, a GOP, an ESD protective circuit, or a metal wire. Herein, structures of the two electronic devices 100c are, for example, the same or different, and a quantity of electronic devices 100c in the tiled electronic device 200a may be adjusted according to a requirement. In some embodiments, the tiled electronic device 200a further includes a joint element 210, located between the two electronic devices 100c. In some embodiments, the joint element 210 is, for example, in contact with the conductive patterns 130a. In some embodiments (not shown), the joint element 210 may, for example, coat the conductive patterns 130a. In some embodiments, a material of the joint element 210 includes, for example but not limited to, a material with a light absorption property, a cushioning property, or a protective property, or a combination of the foregoing materials. In some embodiments, a material of the joint element 210 includes, for example but not limited to, resins (such as epoxy), silicone, or other suitable materials. In some embodiments, another layer (not shown) may be disposed on an outer surface of conductive patterns 130a of another electronic device 100c. The layer includes, for example, a material with a light absorption property, a cushioning property, or a protective property, or a combination of the foregoing materials, and a material the same as or different from that of the joint element 210 may be selected for the layer according to a requirement.

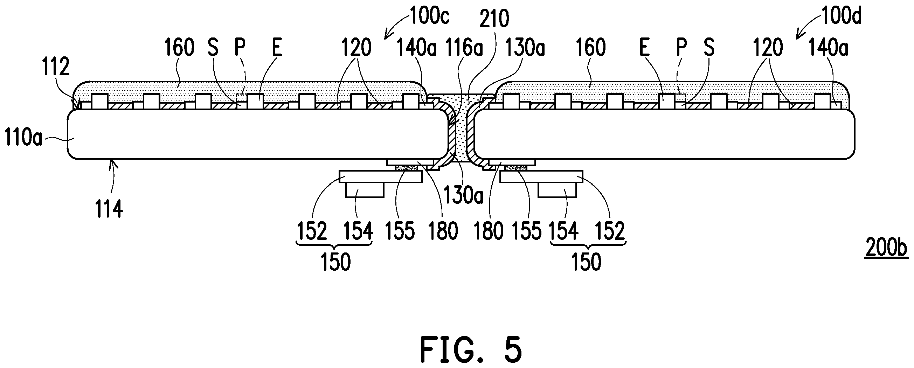

FIG. 5 is a schematic cross-sectional view of a tiled electronic device according to another embodiment of the disclosure. Referring to FIG. 4 and FIG. 5, the tiled electronic device 200b in the present embodiment is similar to the tiled electronic device 200a in FIG. 4, which differ as follows: In the tiled electronic device 200b in the present embodiment, structures of an electronic device 100c (which may be referred to as a first electronic device) and an electronic device 100d (which may be referred to as a second electronic device) are mirror-symmetric. In other words, a conductive pattern 130a of the electronic device 100c and a conductive pattern 130a of the electronic device 100d are adjacent to each other, and are electrically insulated from each other by using a joint element 210. In other words, a pitch is present between the conductive pattern 130a of the electronic device 100c and the conductive pattern 130a of the electronic device 100d, and the pitch can reduce short circuits between the two.

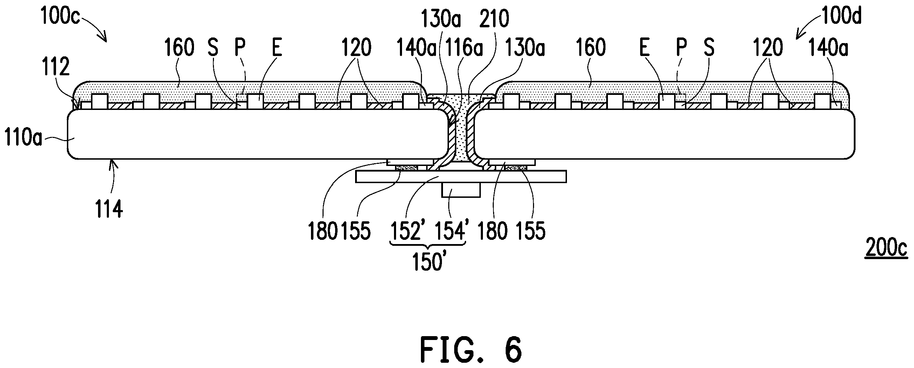

FIG. 6 is a schematic cross-sectional view of a tiled electronic device according to another embodiment of the disclosure. Referring to FIG. 5 and FIG. 6, the tiled electronic device 200c in the present embodiment is similar to the tiled electronic device 200b in FIG. 5, which differ as follows: In the tiled electronic device 200c in the present embodiment, an electronic device 100c (which may be referred to as a first electronic device) and an electronic device 100d (which may be referred to as a second electronic device) disposed side by side share a flexible circuit board 152' and/or an integrated circuit 154' of a same circuit 150'. The electronic device 100c and the electronic device 100d may be controlled by, but not limited to, the circuit 150'.

Based on the above, in the embodiments of the disclosure, in the electronic device, the M of the plurality of signal lines and the N of the plurality of conductive patterns are electrically connected, M and N are natural numbers, and M is greater than N. In other words, the quantity of conductive patterns formed on the third surface (that is, the side surface of the substrate) is less than the quantity of signal lines, which can simplify the process and increase the yield, or achieve a narrow bezel effect, so that the electronic device in the embodiments of the disclosure is more applicable to a tiled device. In addition, the tiled electronic device using the electronic devices in the embodiments of the disclosure can provide visual perception of seamless tiling.

## Claims

1. An electronic device (100a, 100b, 100c, 100d), comprising:
a substrate (110a, 110b, 110c, 110d, 110e), having a first surface (112), a second surface (114) opposite to the first surface (112), and a third surface (116a, 116b, 116c, 116d, 116e) therebetween;
a plurality of signal lines (120), disposed on the first surface (112); and
a plurality of conductive patterns (130a, 130b), directly formed on the third surface (116a, 116b, 116c, 116d, 116e), wherein M of the plurality of signal lines (120) and N of the plurality of conductive patterns (130a, 130b) are electrically connected, M and N are natural numbers, and M is greater than N.

2. The electronic device (100a, 100b, 100c, 100d) according to claim 1, further comprising:
a demux (140a), disposed on the substrate (110a, 110b, 110c, 110d, 110e), wherein the M of the plurality of signal lines (120) and the N of the plurality of conductive patterns (130a, 130b) are selectively and electrically connected via the demux (140a).

3. The electronic device (100a, 100b, 100c, 100d) according to claim 2, further comprising:
a plurality of pixels (P), disposed on the substrate (110a, 110b, 110c, 110d, 110e), wherein the plurality of pixels (P) define an active region, and at least a portion of the demux (140a) is located in the active region.

4. The electronic device (100a, 100b, 100c, 100d) according to claim 1 or claim 2, wherein the M of the plurality of signal lines (120) and the N of the plurality of conductive patterns (130a, 130b) are selectively and electrically connected in a one-to-one fashion.

5. The electronic device (100a, 100b, 100c, 100d) according to claim 1, wherein the plurality of signal lines (120) are a plurality of scan lines or a plurality of data lines.

6. The electronic device (100a, 100b, 100c, 100d) according to claim 1, further comprising:
a circuit (150, 150', 172, 180), disposed on the second surface (114), and electrically connected to the plurality of signal lines (120) via the plurality of conductive patterns (130a, 130b).

7. The electronic device (100a, 100b, 100c, 100d) according to claim 1, wherein M is less than or equal to 16.

8. A tiled electronic device (200a, 200b, 200c), comprising:
a first electronic device (100c) and a second electronic device (100c, 100d) disposed side by side, wherein
each of the first electronic device (100c) and the second electronic device (100c, 100d) comprises:
a substrate (110a, 110b, 110c, 110d, 110e), having a first surface (112), a second surface (114) opposite to the first surface (112), and a third surface (116a, 116b, 116c, 116d, 116e) therebetween;
a plurality of signal lines (120), disposed on the first surface (112); and
a plurality of conductive patterns (130a, 130b), directly formed on the third surface (116a, 116b, 116c, 116d, 116e), wherein M of the plurality of signal lines (120) and N of the plurality of conductive patterns (130a, 130b) are electrically connected, M and N are natural numbers, and M is greater than N.

9. The tiled electronic device (200a, 200b, 200c) according to claim 8, wherein each of the first electronic device (100c) and the second electronic device (100c, 100d) further comprises:
a demux (140a), disposed on the substrate (110a, 110b, 110c, 110d, 110e), wherein the M of the plurality of signal lines (120) and the N of the plurality of conductive patterns (130a, 130b) are selectively and electrically connected via the demux (140a).

10. The tiled electronic device (200a, 200b, 200c) according to claim 9, wherein each of the first electronic device (100c) and the second electronic device (100c, 100d) further comprises:
a plurality of pixels (P), disposed on the substrate (110a, 110b, 110c, 110d, 110e), wherein the plurality of pixels (P) define an active region, and at least a portion of the demux (140a) is located in the active region.

11. The tiled electronic device (200a, 200b, 200c) according to claim 8 or claim 9, wherein the M of the plurality of signal lines (120) and the N of the plurality of conductive patterns (130a, 130b) are selectively and electrically connected in an one-to-one fashion.

12. The tiled electronic device (200a, 200b, 200c) according to claim 8, wherein the plurality of signal lines (120) are a plurality of scan lines or a plurality of data lines.

13. The tiled electronic device (200a, 200b, 200c) according to claim 8, wherein each of the first electronic device (100c) and the second electronic device (100c, 100d) further comprises:
a circuit (150, 150', 172, 180), disposed on the second surface (114), and electrically connected to the plurality of signal lines (120) via the plurality of conductive patterns (130a, 130b).

14. The tiled electronic device (200a, 200b, 200c) according to claim 8, wherein M is less than or equal to 16.
